# EUROPEAN PATENT APPLICATION

(11) **EP 1 860 068 A1**
(43) Date of publication of application: **28.11.2007**
(21) Application number: 04819949.1
(22) Date of filing: 03.12.2004
(51) Int. Cl.: C01G 23/00

(54) **METHOD FOR PRODUCING COMPOSITION FOR FORMING DIELECTRIC FILM ,COMPOSITION FOR FORMING DIELECTRIC FILM AND METHOD FOR PRODUCING SAME**

(71) Applicant: JSR Corporation, Tokyo 104-8410 (JP)
(72) Inventor: The designation of the inventor has not yet been filed
(74) Representative: TBK-Patent
(86) International application number: PCT/JP2004/018065
(87) International publication number: WO 2005/054134

(57) **Abstract**

A method of producing a dielectric-film-forming composition including: (a) dissolving a metal hydroxide including a metal A which is at least one metal selected from Li, Na, Ca, Sr, and Ba and at least one of a metal alkoxide and a metal complex including a metal B which is at least one metal selected from Ti, Zr, Hf, Ta, and Nb in an organic solvent to prepare a solution; and (b) allowing a precursor in the solution prepared in the step (a) to react.

## Description

### TECHNICAL FIELD

The present invention relates to a method of producing a dielectric-film-forming composition, a dielectric-film-forming composition, a dielectric film, and a method of forming the dielectric film.

### BACKGROUND ART

An increase in speed and capacity and a decrease in size will be more and more demanded for devices (e.g. portable telephones) in the information technology field. Therefore, high-performance devices have been widely and extensively researched and developed in order to satisfy such demands. A dielectric material having an ABOx (perovskite) type crystal structure represented by barium titanate, barium strontium titanate, or lead zirconate titanate has been widely used in the electronic device field as the material for a capacitor, memory, and the like. In order to provide such electronic devices with a reduced size and an increased performance, it is indispensable to reduce the thickness of each element. This requires a manufacturing technology for a thin film having excellent performance and dielectric characteristics.

As the method of producing a dielectric thin film, various methods have been studied including physical vapor deposition (PVD) such as sputtering, a vapor phase method such as a chemical vapor deposition (CVD) using a metalorganic compound, and a liquid phase method represented by a sol-gel method.

For example, a crystalline lead zirconate titanate thin film exhibiting excellent dielectric characteristics has been relatively easily obtained by the vapor phase method and the liquid phase method. On the other hand, a practical production method for barium titanate or barium strontium titanate has not been established, although some documents have reported that a barium titanate or barium strontium titanate thin film exhibiting dielectric characteristics has been synthesized by the vapor phase method or the sol-gel method.

As the synthesis method for a barium titanate or barium strontium titanate thin film, the liquid phase method has been considered to be a promising method rather than the vapor phase method due to ease of composition controllability and formability and a reduction in production cost. Therefore, synthesis of a thin film using the sol-gel method or coating/pyrolysis method has been extensively studied. The sol-gel method used herein refers to a synthesis process in which a metal alkoxide sol solution (precursor solution) as the starting raw material is converted into a gel state from a sol state through hydrolysis and polycondensation and then converted into a metal oxide. The thin film formation using the sol-gel method has advantages in comparison with other thin film formation methods such as the vapor phase method (e.g. PVD or CVD) in that the shape and the size of the substrate on which the thin film is formed are limited to only a small extent and an expensive apparatus is not required to form the thin film.

On the other hand, a dielectric film obtained by a known sol-gel method tends to produce cracks during firing. Specifically, cracks occur when producing a dielectric film with a thickness of 200 nm or more by one application/firing step. If the thickness of the dielectric film is 200 nm or less, the dielectric film exhibits a low insulating voltage and a large leakage current. This reduces the applicability of the dielectric film to a capacitor or the like. Therefore, a known sol-gel method requires that the application/firing step be performed a number of times in order to obtain a dielectric film exhibiting a high insulating voltage and a small leakage current.

A dielectric film formed using the liquid phase method such as the sol-gel method is further crystallized by increasing the firing temperature to exhibit a high dielectric constant. However, firing at a high temperature may increase the dielectric loss and the leakage current, whereby the capacitor characteristics may be impaired.

Therefore, a coating material which improves the crack resistance and does not increase the dielectric loss and the leakage current, even if the material is fired at a high temperature, has been demanded for use in the thin film formation method using the liquid phase method.

For example, patent document 1 discloses a method of forming a BaTiO₃ film by crystallizing metal soap of Ba and Ti as the raw material at 600 to 1300°C. However, this method tends to cause cracks to occur and can produce a film with a thickness of only about 100 nm by one application/firing step. Therefore, the application/firing step is repeatedly performed nine times in order to obtain a film with a thickness of 1.0 micrometer. In addition, the patent document 1 does not disclose the electrical characteristics of the resulting film.

A composition in which barium carboxylate, strontium carboxylate, and titanium alkoxide are mixed in an organic solvent is disclosed in patent document 2 aiming at preventing occurrence of cracks. However, the patent document 2 discloses neither a film thickness at which occurrence of cracks can be prevented nor electrical characteristics.

Patent document 3 discloses a crystalline gel dispersion coating solution using a crystalline gel obtained by hydrolysis of an alkoxide of Ba, Ti, or the like. However, this coating solution has a problem because the barium alkoxide used as the raw material is very expensive.

Patent document 4 discloses that barium titanate fine powder is obtained by mixing a barium hydroxide aqueous solution and a titanium alkoxide alcohol solution and allowing the mixture to react at 60 to 100°C. The patent document 4 discloses formation of a capacitor by firing a laminate of a ceramic layer containing a barium titanate fine powder obtained by heating the resulting powder at 950 to 1100°C and an electrode layer. However, the patent document 4 does not disclose a dielectric-forming composition produced using the resulting barium titanate fine powder.

Non-patent document 1 discloses a coating solution obtained by partial hydrolysis of a precursor solution obtained using barium ethoxide, titanium isopropoxide, and methoxyethanol. However, this technology requires that electrical characteristics be measured by performing the application/firing step several times.
Patent document 1: JP-A-1-308801
Patent document 2: Japanese Patent No. 3456305
Patent document 3: JP-A-2002-275390
Patent document 4: JP-A-2002-60219
Non-patent document 1: Mte. RES. Soc. Symp. Proc., Vol. 271, 339 (1992)

### DISCLOSURE OF THE INVENTION

The invention was achieved in view of the above-described situation. An object of the invention is to provide a method of producing a dielectric-film-forming composition which allows a reduction in process temperature and processing in a shorter time when forming a dielectric film having an ABOx-type crystal structure, thereby significantly improving the productivity.

Another object of the invention is to provide a dielectric-film-forming composition which can produce a dielectric film having an ABOx-type crystal structure and exhibiting excellent crack resistance, low dielectric loss, and excellent insulating properties without using an expensive raw material such as an alkoxide of Ba, Sr, Ca, or the like.

A further object of the invention is to provide a dielectric film exhibiting excellent crack resistance, low dielectric loss, and excellent insulating properties, and a method of forming the same.

A method of producing a dielectric-film-forming composition of the invention comprises:
(a) dissolving a metal hydroxide including a metal A which is at least one metal selected from Li, Na, Ca, Sr, and Ba and at least one of a metal alkoxide and a metal complex including a metal B which is at least one metal selected from Ti, Zr, Hf, Ta, and Nb in an organic solvent to prepare a solution; and
(b) allowing a precursor in the solution prepared in the step (a) to react.

In the invention, the term "precursor in the solution prepared in the step (a)" refers to the metal hydroxide and at least one of the metal alkoxide and the metal complex (and/or hydrolysis-condensation product thereof).

In the method of producing a dielectric-film-forming composition of the invention, the reaction in the step (b) may be effected by heating the solution prepared in the step (a).

In the method of producing a dielectric-film-forming composition of the invention, the reaction in the step (b) may be hydrolysis-condensation. In this case, perovskite-type crystal particles with an average particle diameter of 100 nm or less may be formed by the hydrolysis-condensation. Moreover, in this case, the method may further comprise: (c) purifying the perovskite-type crystal particles by using an organic solvent after the step (b).

In the method of producing a dielectric-film-forming composition of the invention, the metal A may be at least one metal selected from Ca, Sr, and Ba; and the metal B may be at least one metal selected from Ti, Zr, and Hf.

A dielectric-film-forming composition of the invention is produced by the above-described method of producing a dielectric-film-forming composition of the invention.

Perovskite-type crystal particles with an average particle diameter of 100 nm or less can be dispersed in the dielectric-film-forming composition of the invention.

A dielectric-film-forming composition of the invention comprises:
(A) a reaction product of A1 and A2, A1 being a metal hydroxide including a metal A which is at least one metal selected from Ba, Sr, and Ca, and A2 being a metal alkoxide including a metal B which is at least one metal selected from Ti, Zr, and Hf and/or a partial hydrolysis-condensation product of the metal alkoxide; and
(B) an organic solvent,
wherein the dielectric-film-forming composition having a molar ratio of the metal A to the metal B of 0.9 to 1.1.

The reaction product may be a crystal particle or an amorphous solid. It is preferable that the reaction product be a crystal particle in order to obtain a dielectric film exhibiting a high dielectric constant.

A method of forming a dielectric film of the invention comprises:
forming a coating film by using the above-described dielectric-film-forming composition of the invention; and
heating the coating film.

A dielectric film of the invention is formed by heating a coating film formed by using the above-described dielectric-film-forming composition of the invention.

The method of producing a dielectric-film-forming composition according to the invention allows a composition to be obtained which can form a dielectric film exhibiting excellent dielectric characteristics under mild temperature conditions of 400°C or less, for example.

When forming a dielectric film using the dielectric-film-forming composition according to the invention, since the formation process of the dielectric film is facilitated in comparison with a known process which requires crystallization by high-temperature firing using a furnace, the productivity can be significantly improved. Moreover, since crystallization at a high temperature is made unnecessary by using the dielectric-film-forming composition according to the invention, a dielectric film exhibiting excellent dielectric characteristics can be formed on various substrates exhibiting low heat resistance to which a known sol-gel method requiring crystallization at a high temperature cannot be applied. On the other hand, since a film can be fired at 700 to 950°C on a substrate exhibiting high heat resistance, a dielectric film exhibiting a high dielectric constant, low dielectric loss, and excellent insulating properties can be obtained.

The method of forming a dielectric film according to the invention allows a dielectric film exhibiting a high dielectric constant, low dielectric loss, and excellent insulating properties to be obtained by forming the dielectric film using the dielectric-film-forming composition according to the invention.

The dielectric film according to the invention is characterized by exhibiting a high dielectric constant, low dielectric loss, and excellent insulating properties.

### BEST MODE FOR CARRYING OUT THE INVENTION

The invention is described below in detail.

### 1. Method of producing dielectric-film-forming composition

A method of producing a dielectric-film-forming composition of the invention comprises:
(a) dissolving a metal hydroxide including a metal A which is at least one metal selected from Li, Na, Ca, Sr, and Ba and at least one of a metal alkoxide and a metal complex including a metal B which is at least one metal selected from Ti, Zr, Hf, Ta, and Nb in an organic solvent to prepare a solution; and
(b) adding water to the solution prepared in the step (a) to allow a precursor in the solution to react.

Each step is described below.

### 1.1. Step of preparing solution (hereinafter also called "step (a)")

In the step (a), at least one metal hydroxide selected from metal hydroxides including the metal A which may form a particle having an ABOx-type crystal structure and at least one of a metal alkoxide and a metal complex including the metal B which may form a particle having an ABOx-type crystal structure are used as the raw materials, and the metal hydroxide and the metal alkoxide and/or the metal complex are dissolved in an organic solvent using a known method.

As examples of the metal A, Li, Na, Ca, Sr, and Ba can be given. The metal A is preferably selected from Ca, Sr, and Ba. As examples of the metal B, Ti, Zr, Hf, Ta, and Nb can be given. The metal B is preferably selected from Ti, Zr, and Hf, and is still more preferably Ti.

The concentration of the metals A and B in the solution is preferably 0.01 to 2.0 mmol/g, more preferably 0.1 to 1.0 mmol/g, and still more preferably 0.2 to 0.8 mmol/g. The ratio of the metal A to the metal B (A/B: molar ratio) is preferably 0.6 to 1.5, more preferably 0.8 to 1.2, and still more preferably 0.9 to 1.1.

The substances used in the step (a) are described below.

### 1.1.1. Metal alkoxide

The metal alkoxide is a compound resulting from the reaction between a metal atom and an alcohol, and is shown by the following general formula (1).

M^{a}(OR¹)ₐ (1)

wherein M represents a metal selected from Ti, Zr, Hf, Ta, and Nb, "a" represents an integer from 4 to 7 corresponding to the valence of the metal M, and R¹ represents a residue resulting from removal of an OH group from an alcohol.

As a preferable example of the alcohol forming the metal alkoxide, an alcohol shown by the following general formula (2) can be given.

R¹OH (2)

wherein R¹ represents a saturated or unsaturated hydrocarbon group having 1 to 6 carbon atoms or an alkoxyl group-substituted hydrocarbon group having 1 to 6 carbon atoms.

When R¹ in the general formula (2) is a saturated or unsaturated hydrocarbon group having 1 to 6 carbon atoms, methanol, ethanol, 1-propanol, 2-propanol, butanol, amyl alcohol, cyclohexanol, and the like can be given as examples of the alcohol.

When R¹ in the general formula (2) is an alkoxyl group-substituted hydrocarbon group having 1 to 6 carbon atoms, methoxymethanol, methoxyethanol, ethoxymethanol, ethoxyethanol, methoxypropanol, ethoxypropanol, propoxypropanol, and the like can be given as examples of the alcohol.

As examples of the metal alkoxide shown by the general formula (1), titanium alkoxides such as tetramethoxytitanium, tetraethoxytitanium, tetrapropoxytitanium, tetraisopropoxytitanium, tetrabutoxytitanium, and tetraisobutoxytitanium, zirconium alkoxides such as tetramethoxyzirconium, tetraethoxyzirconium, tetrapropoxyzirconium, tetraisopropoxyzirconium, and tetrabutoxyzirconium, hafnium alkoxides such as tetramethylhafnium, tetraethylhafnium, tetrapropoxyhafnium, tetraisopropoxyhafnium, and tetrabutoxyhafnium, and the like can be given. The above metal alkoxide may be used as a chelate compound reacted with a ligand such as ethyl acetoacetate, acetylacetone, diacetone alcohol, ethylene glycol monomethyl ether, or ethylene glycol monoethyl ether in order to increase the solubility in the solvent and control the reactivity with water.

### 1.1.2. Metal hydroxide

The metal hydroxide is a compound in which a hydroxyl group is bonded to a metal atom, and is shown by the following general formula (3).

M^{a}(OH)ₐ (3)

wherein M represents a metal selected from Li, Na, Ca, Sr, and Ba, and "a" represents an integer from 1 to 2 corresponding to the valence of the metal M.

The metal hydroxide may be either an anhydride which does not contain water of crystallization or a hydrate containing water of crystallization.

As examples of the metal hydroxide shown by the general formula (3), LiOH, NaOH, Ca(OH)₂, Sr(OH)₂, Ba(OH)₂, Ba(OH)₂·H₂O, Ba(OH)₂·8H₂O, and the like can be given. Of these, Ba(OH)₂·H₂O is preferable.

### 1.1.3. Metal complex

The metal complex is a compound in which an organic compound is coordinated to a metal atom, and is shown by the following general formula (4). A partial hydrolysis-condensation product of the metal complex may be used together with or instead of the metal complex.

M^{a}(OR¹)_{b}L_{c} (4)

wherein M represents a metal selected from Ti, Zr, Hf, Ta, and Nb, "a" represents an integer from 4 to 7 corresponding to the valence of the metal M, "b" represents an integer from 0 to 7, "c" represents an integer from 0 to 7, provided that "a=b+c" is satisfied, R¹ represents a residue resulting from removal of an OH group from an alcohol, and L is a residue (ligand) of an organic compound which can be coordinated to a metal.

As examples of the alcohol, methanol, ethanol, 1-propanol, 2-propanol, butanol, amyl alcohol, cyclohexanol, and the like can be given.

As examples of the organic compound which can be coordinated to a metal, acetone, acetylacetone, methyl acetoacetate, ethyl acetoacetate, monoethanolamine, diethanolamine, triethanolamine, and the like can be given.

As the metal complex shown by the general formula (4), titanium allyl acetoacetate triisopropoxide, titanium dibutoxide (bis-2,4-pentanedionate), titanium diisopropoxide (bis-2,4-pentanedionate), titanium dibutoxide bis(tetramethylheptanedionate), titanium diisopropoxide bis(tetramethylheptanedionate), titanium dibutoxide bis(ethyl acetoacetate), titanium diisopropoxide bis(ethyl acetoacetate), or the like may be preferably used.

### 1.1.4. Organic solvent

As examples of the organic solvent used when dissolving the metal hydroxide and the metal alkoxide and/or the metal complex, an alcohol solvent, polyhydric alcohol solvent, ether solvent, ketone solvent, ester solvent, and the like can be given.

As examples of the alcohol solvent, methanol, ethanol, propanol, isopropanol, n-butanol, i-butanol, sec-butanol, amyl alcohol, cyclohexanol, methylcyclohexanol, furfuryl alcohol, and the like can be given.

As examples of the polyhydric alcohol solvent, ethylene glycol, propylene glycol, butylene glycol, hexylene glycol, ethylene glycol monomethyl ether, ethylene glycol monoethyl ether, ethylene glycol monopropyl ether, ethylene glycol monobutyl ether, ethylene glycol monoacetate, diethylene glycol monomethyl ether, diethylene glycol monoacetate, propylene glycol monoethyl ether, propylene glycol monoacetate, dipropylene glycol monoethyl ether, propylene glycol monomethyl ether, propylene glycol monopropyl ether, methoxybutanol, propylene glycol monoethyl ether acetate, propylene glycol monomethyl ether acetate, dipropylene glycol propyl ether, dipropylene glycol monobutyl ether, and the like can be given.

As examples of the ether solvent, dimethyl ether, diethyl ether, dipropyl ether, dibutyl ether, diamyl ether, diethyl acetal, dihexyl ether, trioxane, dioxane, tetrahydrofuran, methyl cellosolve, ethyl cellosolve, butyl cellosolve, and the like can be given.

As examples of the ketone solvent, acetone, methyl ethyl ketone, methyl propyl ketone, methyl isobutyl ketone, methyl amyl ketone, methyl cyclohexyl ketone, diethyl ketone, ethyl butyl ketone, trimethyl nonanone, acetonylacetone, dimethyl oxide, phorone, cyclohexanone, diacetone alcohol, and the like can be given.

As examples of the ester solvent, ethyl formate, methyl acetate, ethyl acetate, butyl acetate, cyclohexyl acetate, methyl propionate, ethyl butyrate, ethyl oxyisobutyrate, ethyl acetoacetate, ethyl lactate, methoxybutyl acetate, diethyl oxalate, diethyl malonate, and the like can be given.

A hydrophilic solvent is preferable as the organic solvent. The organic solvent may be used individually or in combination of two or more.

### 1.1.5. Solution

In the invention, a lanthanoid compound may be added to the solution obtained in the step (a). As examples of the lanthanoid, La, Ce, Pr, Nd, Pm, Sm, Eu, Gd, Tb, Dy, Ho, Er, and Tm can be given. The lanthanoid compound is preferably used as an alkoxide, halide, carboxylate, or hydroxide of the lanthanoid.

### 1.2. Step of allowing precursor in solution to react (hereinafter also called "step (b)")

In the step (b), the precursor in the solution prepared in the step (a) is allowed to react. This yields a reaction product. The reaction may be condensation (e.g. hydrolysis-condensation). The reaction product may be an amorphous solid and/or a crystal particle. Specifically, the reaction product may be a crystal particle or an amorphous solid. It is preferable that the reaction product be a crystal particle in order to obtain a dielectric film exhibiting a high dielectric constant.

The reaction product may be obtained by the following first or second method, for example. The first and second methods are described below.

### 1.2.1. First method

The first method is a method in which the reaction product (perovskite-type crystal particle having ABOx-type crystal structure) is obtained by allowing the precursor in the solution prepared in the step (a) to react (hydrolysis-condensation). A crystal particle exhibiting excellent crystallinity can be obtained by the first method.

In the first method, the precursor in the solution prepared in the step (a) may be crystallized in the step (b) by maintaining the solution at a temperature of preferably -78 to 200°C, more preferably -20 to 100°C, and still more preferably 0 to 50°C, and adding water to the solution in an amount of usually 5 to 300 mol, preferably 10 to 200 mol, and still more preferably 20 to 100 mol for 1 mol of the metal A to allow the precursor in the solution to undergo hydrolysis-condensation.

The hydrolysis-condensation may be carried out by adding water to the solution prepared in the step (a). When the solution contains water, water may not be added.

In the case of adding water to the solution when allowing the precursor to undergo hydrolysis-condensation, it is preferable to add water in an amount within the above-mentioned range with respect to the metal A in order to obtain a particle exhibiting excellent crystallinity. If the amount of water added is less than the lower limit or greater than the upper limit, the crystallinity of the particle may be decreased.

In the step (b), only water may be directly added to the solution, or water may be added as a mixture with at least one of the organic solvents given in the section 1.4.

The hydrolysis-condensation can be efficiently carried out with excellent reproducibility by adding only water or an organic solvent containing water dropwise to the solution in the step (b) as water for effecting the hydrolysis-condensation.

A catalyst may be contained in water to be added. As examples of the catalyst which may be used, acid catalysts such as inorganic acids (e.g. hydrochloric acid, sulfuric acid, and nitric acid) and organic acids (e.g. acetic acid, propionic acid, butyric acid, and maleic acid), inorganic or organic alkali catalysts such as sodium hydroxide, potassium hydroxide, barium hydroxide, ammonia, monoethanolamine, diethanolamine, and tetramethylammonium hydroxide, and the like can be given.

It is preferable to use the alkali catalyst. When using the organic acid such as a carboxylic acid, carbon dioxide produced due to decomposition of the organic acid may remain in the resulting film to affect the electrical characteristics of the resulting dielectric film. When using the inorganic acid such as hydrochloric acid or nitric acid, part of the acid component may remain in the resulting film to decrease the leakage current characteristics of the resulting dielectric film.

After adding water to the solution, the resulting hydrolysis-condensation product is preferably maintained at a temperature of usually -10 to 200°C, preferably 20 to 150°C, and still more preferably 30 to 100°C for usually 0.5 to 200 hours, preferably 1 to 100 hours, and still more preferably 3 to 20 hours.

### 1.2.2. Second method

The second method is a method in which the precursor in the solution prepared in the step (a) is allowed to react by heating the solution. The reaction refers to condensation, for example. The second method allows at least an amorphous solid to be obtained as the reaction product by heating.

In particular, when the metal A forming the metal hydroxide (A1) contained in the solution prepared in the step (a) is at least one metal atom selected from Ba, Sr, and Ca, the metal B forming the metal alkoxide and/or partial hydrolysis-condensation product thereof (A2) is at least one metal atom selected from Ti, Zr, and Hf, and the molar ratio of the metal A to the metal B is 0.9 to 1.1, the reaction product can be easily obtained by heating the solution. If the molar ratio of the metal A to the metal B is less than 0.9, the dielectric constant of a dielectric film formed using the resulting dielectric-film-forming composition may be decreased. If the molar ratio of the metal A to the metal B is greater than 1.1, the insulating properties of a dielectric film formed using the resulting dielectric-film-forming composition may be decreased.

When water exists in the reaction system, hydrolysis-condensation may be caused to proceed by heating the solution without adding water, as described in the first method. For example, when the metal hydroxide is a hydrate (e.g. barium hydroxide monohydrate), since water originating in the hydrate exists in the reaction system, hydrolysis-condensation can be easily caused to proceed by heating the solution without adding water, whereby a crystal particle can be more easily obtained.

In the second method, the reaction product can be obtained in the step (b) by allowing the precursor in the solution prepared in the step (a) to react by heating the solution at a temperature of preferably 60°C or more, more preferably 100°C or more, and still more preferably 130°C or more.

As described above, the invention allows the amorphous solid and/or the perovskite-type crystal particles to be obtained through the step (a) and the step (b). The resulting perovskite-type crystal particles have an ABOx-type crystal structure and have an average particle diameter of preferably 100 nm or less, and still more preferably 50 nm or less.

### 1.3. Dispersion step

When the reaction product obtained by the steps (a) and (b) is crystal particles, the crystal particles may be dispersed in an organic solvent (hereinafter called "dispersion step"). This allows a perovskite-type crystal particle dispersion (dielectric-film-forming composition) according to the invention to be obtained. It is preferable that the perovskite-type crystal particles contained in the dispersion have an ABOx-type crystal structure and have an average particle diameter of 100 nm or less (more preferably 50 nm or less), as described above.

In this case, the method preferably further includes (c) purifying the perovskite-type crystal particles using an organic solvent before the dispersion step. Impurities can be removed by this step.

The crystal particle produced by crystallizing the reaction product (hydrolysis-condensation product) as described above contains impurities such as unreacted metal alkoxide, metal carboxylate, and metal complex (hereinafter also called "metalorganic compound"), metalorganic compound which has undergone partial hydrolysis-condensation, metal hydroxide produced by complete hydrolysis-condensation of the metalorganic compound, and metal ions. If the concentration of the metal A in the impurities is higher than 1 mol% in the dielectric-film-forming composition in which such crystal particles are directly dispersed in the organic solvent, when forming a dielectric film using the dielectric-film-forming composition, (1) the leakage current may be increased due to the ionic conductivity of the dielectric film, and (2) the dielectric loss of the dielectric film may be increased.

The method of purifying the crystal particles obtained by the step (b) using an organic solvent is not particularly limited insofar as the crystal particles and the organic solvent can be separated after purification. The crystal particles may be purified using a method in which a step of adding the organic solvent to the crystal particles, causing the crystal particles to precipitate by decantation or centrifugation, removing the supernatant liquid, adding the organic solvent to the precipitated crystal particles, and heating the mixture is repeatedly performed two to five times. The impurities and water contained in the crystal particles can be removed by this method, whereby the concentrations of the impurities and water can be reduced. The concentrations of the impurities and water can also be reduced by adding the particles to the organic solvent and repeatedly performing dialysis using a semipermeable membrane two to five times, for example.

Specifically, when a dielectric-film-forming composition (crystal particle dispersion) is obtained by dispersing the purified crystal particles in the organic solvent, the concentration of the metal A in the impurities and the concentration of water in the dielectric-film-forming composition can be reduced to specific concentrations, whereby the above-described problems (1) and (2) can be eliminated.

As examples of the organic solvent used in the purification step, an alcohol solvent, polyhydric alcohol solvent, ether solvent, ketone solvent, ester solvent, amide solvent, and the like can be given.

As examples of the alcohol solvent, methanol, ethanol, propanol, butanol, amyl alcohol, cyclohexanol, methylcyclohexanol, and the like can be given.

As examples of the polyhydric alcohol solvent, ethylene glycol derivatives such as ethylene glycol monomethyl ether, ethylene glycol monoacetate, diethylene glycol monomethyl ether, and diethylene glycol monoacetate, propylene glycol derivatives such as propylene glycol monoethyl ether, propylene glycol monoacetate, dipropylene glycol monoethyl ether, propylene glycol monomethyl ether, propylene glycol monopropyl ether, methoxybutanol, propylene glycol monoethyl ether acetate, propylene glycol monomethyl ether acetate, dipropylene glycol propyl ether, and dipropylene glycol monobutyl ether, and the like can be given.

As examples of the ether solvent, methylal, diethyl ether, dipropyl ether, dibutyl ether, diamyl ether, diethyl acetal, dihexyl ether, trioxane, dioxane, methyl cellosolve, ethyl cellosolve, butyl cellosolve, and the like can be given.

As examples of the ketone solvent, acetone, methyl ethyl ketone, methyl propyl ketone, methyl isobutyl ketone, methyl amyl ketone, methyl cyclohexyl ketone, diethyl ketone, ethyl butyl ketone, trimethyl nonanone, acetonylacetone, dimethyl oxide, phorone, cyclohexanone, diacetone alcohol, and the like can be given.

As examples of the ester solvent, ethyl formate, methyl acetate, ethyl acetate, butyl acetate, cyclohexyl acetate, methyl propionate, ethyl butyrate, ethyl oxyisobutyrate, ethyl acetoacetate, ethyl lactate, methoxybutyl acetate, diethyl oxalate, diethyl malonate, and the like can be given.

As examples of the amide solvent, amides such as dimethylformamide, dimethylacetamide, and N-methylpyrrolidone, and the like can be given.

The above organic solvent may be used individually or in combination of two or more.

A dielectric-film-forming composition (crystal particle dispersion) may also be produced by separating the crystal particles obtained according to the invention from the organic solvent as the washing liquid, placing the crystal particles in another organic solvent, and dispersing the crystal particles.

In this case, the crystal particles may be dispersed in the organic solvent using an arbitrary method insofar as the crystal particles can be uniformly dispersed in the organic solvent. For example, the crystal particles may be dispersed in the solvent with mechanical stirring or stirring using ultrasonic waves.

As examples of the organic solvent used for dispersion, an alcohol solvent, polyhydric alcohol solvent, ether solvent, ketone solvent, and ester solvent similar to those given as examples of the organic solvent used in the purification step can be given. In more detail, methyl cellosolve, the ethylene glycol derivative, or the propylene glycol derivative is preferable as the organic solvent used for dispersion. It is preferable to use a hydrophilic solvent since the crystal particles can be dissolved and coating characteristics can be provided when forming a coating by spin coating or the like.

The above organic solvent may be used individually or in combination of two or more. The organic solvent used for dispersion may be the same as or different from the organic solvent used for purification.

The crystal particle content (solid content) of the dielectric-film-forming composition is 1 to 20 wt%, and preferably 3 to 15 wt% of the total amount of the dielectric-film-forming composition taking the stability of the dielectric-film-forming composition (crystal particle dispersion) into consideration.

In the dispersion step, a nonionic surfactant, anionic surfactant, or cationic surfactant may be used as a dispersant when dispersing the purified crystal particles in the organic solvent in order to facilitate dispersion of the crystal particles. As the surfactant, polyoxyethylene-polyoxypropylene glycol, a polyoxypropylene-polyoxyethylene glycol condensate of ethylenediamine (pluronic type), sodium alkylbenzene sulfonate, polyethylenimine, polyvinylpyrrolidone, a perfluoroalkyl group-containing oligomer, or the like may be used.

The type and the amount of dispersant may be arbitrarily selected depending on the type of crystal particles and the type of solvent in which the crystal particles are dispersed. The dispersant is added in an amount of preferably 0.001 to 10 g, more preferably 0.005 to 3 g, and still more preferably 0.01 to 1 g for 100 g of the particles taking the dielectric characteristics of the resulting dielectric film into consideration.

A high-dielectric-constant filler such as barium titanate, PZT, or PMN may also be added to the dielectric-film-forming composition according to the invention. In this case, it is preferable to use a filler having a particle diameter of 1 micrometer or less.

### 2. Dielectric film and its formation method

A dielectric film may be formed by applying the dielectric-film-forming composition (crystal particle dispersion) obtained by dispersing the crystal particles produced according to the invention in the organic solvent to a substrate to form a coating film, and arbitrarily drying the coating film, preferably followed by firing by heating.

In more detail, the dielectric-film-forming composition is applied to the substrate to form a coating film. The dielectric-film-forming composition may be applied to the substrate using a known coating method such as open spin coating, closed spin coating, liquid source misted chemical vapor deposition (LSM-CVD), dipping, spraying, roll coating, printing, inkjetting, or electrophoretic coating.

The coating film is dried at a temperature of usually 50 to 300°C, and preferably 100 to 250°C.

A dielectric film having a desired thickness can be obtained by repeatedly performing a series of operations including applying the dielectric-film-forming composition to the substrate and arbitrary drying the coating film several times.

The coating film is then fired by heating at a temperature of more than 300°C and 900°C or less, and preferably 400 to 750°C to obtain a dielectric film. Specifically, when using the dielectric-film-forming composition, not only a dielectric film can be obtained by firing the coating film at a high temperature in the same manner as in a known method, but also a dielectric film appropriate for practical applications can be obtained by firing the coating film at a temperature lower than that of a known method, such as 400°C or less.

The form of the substrate to which the dielectric-film-forming composition is applied is not particularly limited insofar as a desired coverage can be realized. That is, the substrate may be a planar substrate or a nonplanar substrate (e.g. stepped substrate). The shape of the substrate is not particularly limited. For example, a bulk substrate or a substrate in the shape of a thin plate or a film may be used. As specific examples of the material for the substrate, a semiconductor, glass, metal, plastic, and ceramic can be given.

As examples of the semiconductor substrate, a silicon wafer and the like can be given. An electrode or the like may be formed on the silicon wafer using a silicon oxide film, a metal such as Pt, Ir, or Ru, or a conductive metal oxide which is an oxide of such a metal. A compound semiconductor substrate made of GaAs, InP, or the like may also be used as the substrate.

As the glass substrate, a substrate made of quartz glass, borosilicate glass, soda glass, lead glass, lanthanum glass, or the like may be used.

As the metal substrate, a substrate made of gold, silver, copper, nickel, aluminum, iron, stainless steel, or the like may be used.

As the plastic substrate, a substrate made of a polyimide, methacrylic resin, or the like may be used. The plastic substrate may have a heat resistance lower than that of the glass substrate or the metal substrate. However, since the invention allows formation of a dielectric film (crystallized film) at a low temperature, no fundamental problem occurs when applying the invention.

As the ceramic substrate, a substrate made of silicon oxide, aluminum oxide, titanium oxide, silicon nitride, aluminum nitride, titanium nitride, silicon carbide, titanium carbide, or the like may be used.

Since the dielectric film obtained as described above exhibits excellent dielectric characteristics and leakage current characteristics, the dielectric film may be suitably used for electronic parts such as a capacitor.

### 3. Examples

The invention is described below in more detail by way of examples. Note that the invention is not limited to the following examples.

### 3.1. Example 1

### 3.1.1. Experimental Example 1

### 3.1.1-1. Production of crystal particle A-1 and dielectric-film-forming composition (crystal particle dispersion) a-1

28.4 g (100 mmol) of Ti(OCH(CH₃)₂)₄ was added to 152.7 g of methyl cellosolve. The mixture was then stirred at room temperature for one hour. After the addition of 19.3 g (100 mmol) of Ba(OH)₂·H₂O having a purity of 98% to the resulting solution, the mixture was heated at 60°C for three hours to dissolve the Ba(OH)₂·H₂O. After cooling the mixture to room temperature, insoluble components were filtered through a filter with a pore size of three micrometers to prepare a raw material solution 1 having a Ba concentration of 0.5 mmol/g and a Ti concentration of 0.5 mmol/g.

After cooling the raw material solution 1 (40 g) to 5°C, a mixed solution of 10.8 g of water and 10.8 g of methanol in an amount (mol) 30 times the amount of Ba was added to the raw material solution 1 with stirring to obtain a reaction product (hydrolysis-condensation product). The reaction product was then crystallized at 60°C for five hours.

After crystallization, the crystal particles and the supernatant liquid were separated by decantation. After the addition of 120 g of methyl cellosolve, the mixture was allowed to stand at 60°C for three hours. The above operation was repeatedly performed twice to obtain purified crystal particles A-1.

After separating the crystal particles A-1 and the supernatant liquid, methyl cellosolve was added so that the solid content when converted to BaTiO₃ was 15 wt%. After the addition of a polyoxypropylene-polyoxyethylene condensate of ethylenediamine as a dispersant in an amount of 0.1 g for 100 g of the particles, the crystal particles A-1 were dispersed using an ultrasonic disperser to obtain a dielectric-film-forming composition a-1.

The particle diameter distribution of the crystal particles in the dielectric-film-forming composition a-1 was measured by a dynamic light scattering method using a dynamic light scattering particle diameter distribution measuring device "LB-500" (manufactured by Horiba, Ltd.). As a result, the median diameter was found to be 22 nm. Note that large particles could be easily removed from the dielectric-film-forming composition a-1 by filtration through a filter with a pore size of 200 nm.

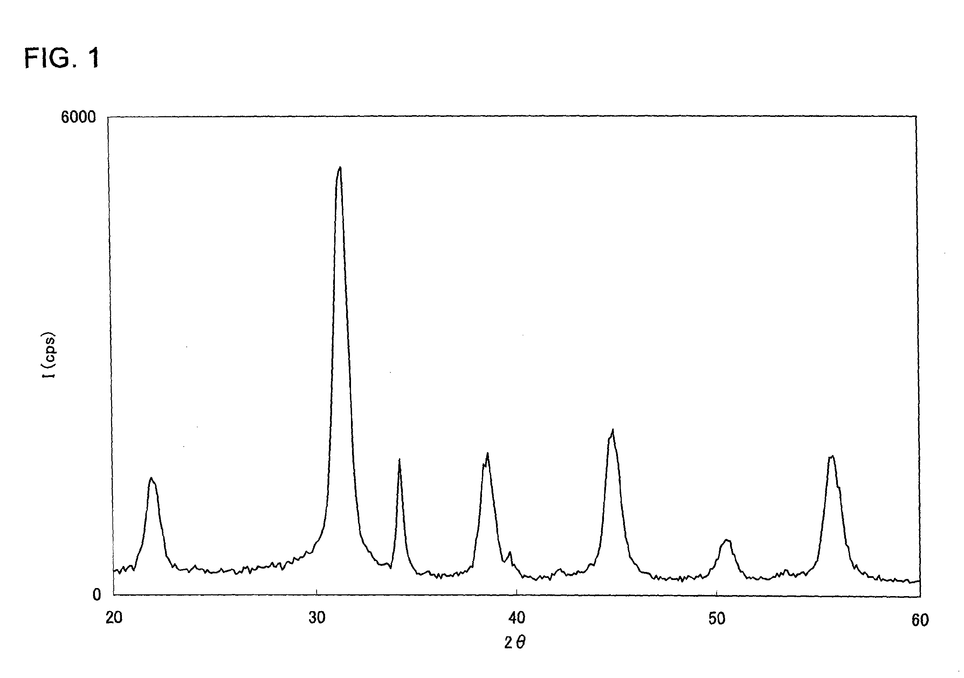

FIG. 1 shows an X-ray diffraction chart of a thin film obtained by applying the dielectric-film-forming composition a-1 dropwise to a glass plate and drying the applied composition at room temperature. As shown in FIG. 1, it was confirmed that the crystal particle A-1 formed an ABOx-type crystal structure of a BaTiO₃ complex oxide at room temperature.

### 3.1.2. Experimental Examples 2 to 5

Crystal particles A-2 to A-5 were obtained using the raw material solution 1 under conditions shown in Table 1. The resulting crystal particles were treated in the same manner as in Experimental Example 1 to obtain dielectric-film-forming compositions a-2 to a-5. Thin films were formed in the same manner as in Experimental Example 1 using the dielectric-film-forming compositions a-2 to a-5. Table 1 shows analysis results of the X-ray diffraction chart (XRD) of the resulting thin films and the median diameters of the dielectric-film-forming compositions a-2 to a-5.

### 3.1.3. Experimental Example 6

19.3 g (100 mmol) of Ba(OH)₂·H₂O having a purity of 98% was added to 100 g of methanol. The mixture was then stirred for three hours to dissolve the Ba(OH)₂·H₂O. Insoluble components were filtered through a filter with a pore size of 3 micrometers to obtain a methanol solution of barium hydroxide. Another vessel was charged with 15.2 g of methyl cellosolve and 28.4 g (100 mmol) of Ti(OCH(CH₃)₂)₄. The mixture was then stirred at room temperature for one hour. The above methanol solution of barium hydroxide and methyl cellosolve were added to the mixture to prepare a raw material solution 2 having a Ba concentration of 0.5 mmol/g and a Ti concentration of 0.5 mmol/g.

After cooling the raw material solution 2 (40 g) to 5°C, a mixed solution of 10.8 g of water and 10.8 g of methanol in an amount (mol) 30 times the amount of Ba was added to the raw material solution 2 with stirring to obtain a reaction product (hydrolysis-condensation product). The reaction product was then crystallized at 60°C for five hours.

After crystallization, the crystal particles and the supernatant liquid were separated by decantation. After the addition of 120 g of methyl cellosolve, the mixture was allowed to stand at 60°C for three hours. The above operation was repeatedly performed twice to obtain purified crystal particles A-6.

After separating the crystal particles A-6 and the supernatant liquid, methyl cellosolve was added so that the solid content when converted to BaTiO₃ was 15 wt%. After the addition of a polyoxypropylene-polyoxyethylene condensate of ethylenediamine as a dispersant in an amount of 0.1 g for 100 g of the particles, the crystal particles A-6 were dispersed using an ultrasonic disperser to obtain a dielectric-film-forming composition a-6.

**TABLE 1**

| | Composition | Ba concentration (mmol/g) | Ti concentration (mmol/g) | Amount of water (H₂O/Ba (molar ratio)) | Reaction conditions | XRD analysis results | Median diameter (nm) |
|---|---|---|---|---|---|---|---|
| Experimental Example 2 | a-2 | 0.5 | 0.5 | 20 | 60°C, 5 hr | BaTiO₃ crystal | 15 |
| Experimental Example 3 | a-3 | 0.5 | 0.5 | 90 | 60°C, 5 hr | BaTiO₃ crystal | 42 |
| Experimental Example 4 | a-4 | 0.3 | 0.3 | 20 | 60°C, 5 hr | BaTiO₃ crystal | 12 |
| Experimental Example 5 | a-5 | 0.5 | 0.5 | 20 | 170°C, 6 hr* | BaTiO₃ crystal | 23 |
| Experimental Example 6 | a-6 | 0.5 | 0.5 | 30 | 60°C, 5 hr | BaTiO₃ crystal | 24 |

| | | | | | | | |
|---|---|---|---|---|---|---|---|
| * The reaction was carried out by using a Teflon autoclave. | | | | | | | |

### 3.1.4. Test

### 3.1.4-1. Formation of dielectric films 1 to 7 using dielectric-film-forming compositions a-1 to a-6

A Pt lower electrode with a thickness of 100 nm was formed by sputtering on a 6-inch silicon wafer on which a silicon oxide layer with a thickness of 1000 nm was formed by a thermal oxidation method.

The dielectric-film-forming compositions a-1 to a-6 were respectively applied to the lower electrode using a spin coater at 300 rpm for five seconds and at 1000 rpm for 20 seconds, and then dried at 250°C for one minute. The coating films were heated at 400°C for one minute and fired at 750°C for 60 minutes to obtain six dielectric films with a thickness of about 250 nm. The dielectric films were observed with the naked eye and using a microscope. Occurrence of cracks was not observed.

The dielectric-film-forming composition a-1 was applied to the lower electrode using a spin coater at 300 rpm for five seconds and at 1000 rpm for 20 seconds, and then dried at 250°C for one minute. The coating film was then fired at 400°C for 60 minutes to obtain a dielectric film with a thickness of about 270 nm.

### 3.1.4-2. Dielectric characteristics of dielectric films 1 to 7

A Pt upper electrode with a diameter of 0.2 mm and a thickness of 200 nm was formed by sputtering on each of the dielectric films 1 to 7 through a metal mask to obtain seven samples.

Table 2 shows the relative dielectric constant, dielectric loss, and leakage current at 0.2 mV/cm of each dielectric film measured at 1 MHz. As is clear from Table 2, it was confirmed that the dielectric films 1 to 7 exhibited a high dielectric constant, low dielectric loss, and small leakage current and can be suitably used for a capacitor. It was also confirmed that the dielectric film exhibited a high dielectric constant even when fired at a low temperature of 400°C.

**TABLE 2**

| Dielectric film | Composition | Firing conditions | Relative dielectric constant | Dielectric loss (%) | Leakage current (A/cm²) |
|---|---|---|---|---|---|
| 1 | a-1 | 750°C, 60 min | 262 | 0.05 | 3.50E-07 |
| 2 | a-1 | 400°C, 60 min | 83 | 0.06 | 5.30E-07 |
| 3 | a-2 | 750°C, 60 min | 312 | 0.06 | 4.30E-07 |
| 4 | a-3 | 750°C, 60 min | 230 | 0.04 | 6.20E-07 |
| 5 | a-4 | 750°C, 60 min | 285 | 0.05 | 2.20E-07 |
| 6 | a-5 | 750°C, 60 min | 295 | 0.03 | 7.30E-08 |
| 7 | a-6 | 750°C, 60 min | 180 | 0.06 | 4.30E-07 |

### 3.2. Example 2

### 3.2.1. Experimental Example 7

28.4 g (100 mmol) of Ti(OCH(CH₃)₂)₄ was added to 152.7 g of ethylene glycol monomethyl ether. The mixture was then stirred at room temperature for one hour. After the addition of 19.3 g (100 mmol) of Ba(OH)₂·H₂O having a purity of 98% to the resulting solution, the mixture was heated at 60°C for three hours to dissolve the Ba(OH)₂·H₂O. After the addition of 49.6 g of ethylene glycol monomethyl ether, the mixture was allowed to react at 80°C for three hours to obtain a reddish brown transparent solution. After cooling the solution to room temperature, insoluble components were filtered through a filter with a pore size of 0.2 micrometers to prepare a dielectric-film-forming composition a-7 in which "Ba/Ti=1/1 (mol/mol)".

### 3.2.2. Experimental Example 8

28.4 g (100 mmol) of Ti(OCH(CH₃)₂)₄ was added to 152.7 g of ethylene glycol monomethyl ether. The mixture was then stirred at room temperature for one hour. After the addition of 19.3 g (100 mmol) of Ba(OH)₂·H₂O having a purity of 98% to the resulting solution, the mixture was heated at 60°C for three hours to dissolve the Ba(OH)₂·H₂O. After cooling the mixture to room temperature, insoluble components were filtered through a filter with a pore size of one micrometer. The resulting solution was placed in a reactor equipped with a stirrer and a reflux condenser and heated to 130°C. The solution became turbid and precipitation of crystal particles occurred about 30 minutes after heating. The components were allowed to react at 130°C for 4.5 hours. After cooling the solution to room temperature, methyl cellosolve was added so that the solid content when converted to BaTiO₃ was 12 wt%. After the addition of a polyoxypropylene-polyoxyethylene condensate of ethylenediamine as a dispersant in an amount of 0.2 g for 100 g of the solid content, the crystal particles were dispersed using an ultrasonic disperser. Large particles were filtered through a filter with a pore size of 0.2 micrometers to obtain a dielectric-film-forming composition a-8.

### 3.2.3. Experimental Examples 9 to 12

In Experimental Examples 9 to 12, solutions were prepared in the same manner as in Experimental Example 8 except for using the raw materials at a ratio shown in Table 3 and changing the reaction temperature and the reaction time as shown in Table 1. The resulting solutions were subjected to ultrasonic treatment and filtration in the same manner as in Experimental Example 8 to obtain dielectric-film-forming compositions a-9 to a-12.

Table 3 shows the median diameters of the reaction products (crystal particles) contained in the dielectric-film-forming compositions a-7 to a-12 obtained in Experimental Examples 7 to 12. The median diameter was determined by measuring the particle diameter distribution of the particles contained in each dielectric-film-forming composition by a dynamic light scattering method using a dynamic light scattering particle diameter distribution measuring device "LB-500" (manufactured by Horiba, Ltd.).

**TABLE 3**

| | Composition | (A1) | (A2) component 1 | (A2) component 2 | (B) organic solvent | Reaction temperature | Reaction time | Median diameter |
|---|---|---|---|---|---|---|---|---|
| Experimental Example 7 | a-7 | 100 mmol | 100 mmol | - | EGME | 60°C | 3 hr | - |
| Experimental Example 8 | a-8 | 100 mmol | 100 mmol | - | EGME | 130°C | 4.5 hr | 45 nm |
| Experimental Example 9 | a-9 | 100 mmol | 101 mmol | - | EGME | 130°C | 5 hr | 46 nm |
| Experimental Example 10 | a-10 | 100 mmol | 85 mmol | 15 mmol | EGME | 130°C | 5 hr | 52 nm |
| Experimental Example 11 | a-11 | 100 mmol | 100 mmol | - | EGBE | 150°C | 5 hr | 49 nm |
| Experimental Example 12 | a-12 | 100 mmol | 100 mmol | - | EGME | 180°C*¹ | 7 hr | 54 nm |
| Comparative Example 1 | a-13 | See description given later | | | | | | |
| Comparative Example 2 | a-14 | 85 mmol | 100 mmol | - | EGME | 130°C | 5 hr | 43 nm |
| Comparative Example 3 | a-15 | 115 mmol | 100 mmol | - | EGME | 130°C | 5 hr | 62 nm |

| | | | | | | | | |
|---|---|---|---|---|---|---|---|---|
| (A1): barium hydroxide monohydrate (A2) component 1: titanium isopropoxide (A2) component 2: zirconium butoxide EGME: ethylene glycol monomethyl ether EGBE: ethylene glycol monobutyl ether * 1: The reaction was carried out under pressurized conditions by using an autoclave with Teflon (registered trademark) lining. | | | | | | | | |

### 3.2.4. Comparative Example

### 3.2.4-1. Comparative Example 1

Ba(OCH₂CH₂OCH₃)₂ was synthesized from Ba and methylene glycol monomethyl ether and Ti(OCH₂CH₂OCH₃)₄ was synthesized from titanium isopropoxide and methylene glycol monomethyl ether according to the method disclosed in the non-patent document 1. After the addition of the methylene glycol monomethyl ether solution of Ti(OCH₂CH₂OCH₃) to Ba(OCH₂CH₂OCH₃)₂ in an equimolar amount, the mixture was refluxed with heating at 130°C for two hours to obtain a reaction product with a concentration of 0.4 M. H₂O was added to the reaction product in an amount of one equivalent to effect partial hydrolysis to obtain a composition a-13.

### 3.2.4-2. Comparative Examples 2 and 3

In Comparative Examples 2 and 3, solutions were prepared in the same manner as in Experimental Example 8 except for using the raw materials at a ratio shown in Table 1 and changing the reaction temperature and the reaction time as shown in Table 1. The resulting solutions were subjected to ultrasonic treatment and filtration in the same manner as in Experimental Example 8 to obtain compositions a-14 and a-15.

### 3.2.5 Evaluation

### 3.2.5-1. X-ray diffraction analysis

The compositions a-7 to a-15 obtained in Experimental Examples 7 to 12 and Comparative Examples 1 to 3 were respectively dropped onto a glass plate and dried at room temperature to form thin films. The resulting thin films were subjected to X-ray diffraction analysis. As is clear from the measurement results, it was confirmed that the dielectric-film-forming composition a-7 was amorphous because the peak originating in the BaTiO₃ crystal structure was weak. The dielectric-film-forming compositions a-8 to a-12 and the composition a-15 showed a clear peak originating in the BaTiO₃ crystal structure in the X-ray diffraction chart. Therefore, it was confirmed that the dielectric-film-forming compositions a-8 to a-12 and the composition a-15 contained particles having a perovskite-type crystal structure.

### 3.2.5-2. Evaluation of crack resistance

A TiO₂ film with a thickness of 100 nm and a Pt lower electrode with a thickness of 100 nm were formed by sputtering in that order on a 6-inch silicon wafer on which a silicon oxide layer with a thickness of 1000 nm was formed by a thermal oxidation method.

The dielectric-film-forming composition a-7 was applied to the lower electrode using a spin coater at 300 rpm for five seconds and at 2000 rpm for 20 seconds, and then dried at 250°C for one minute. The dielectric-film-forming composition a-7 was again applied to the lower electrode using a spin coater at 300 rpm for five seconds and at 2000 rpm for 20 seconds, and then dried at 250°C for one minute. The resulting coating film was fired at 750°C for 60 minutes to obtain a dielectric film 8 with a thickness of about 300 nm. The dielectric film 8 was observed with the naked eye and using a microscope.

Occurrence of cracks was not observed.

In the evaluation of the dielectric-film-forming compositions a-8 to a-12, a-14, and a-15, a lower electrode was formed on the silicon oxide layer in the same manner as in the above crack resistance evaluation. The dielectric-film-forming compositions a-8 to a-12 were respectively applied to the lower electrode using a spin coater at 300 rpm for five seconds and at 1000 rpm for 20 seconds, and then dried at 250°C for one minute. The resulting coating films were fired at 700°C for 60 minutes to obtain dielectric films 9 to 13 with a thickness of about 270 nm. The dielectric films 9 to 13 were observed with the naked eye and using a microscope. As a result, occurrence of cracks was not observed.

In the evaluation of the composition a-13 according to Comparative Example 1, a lower electrode was formed on the silicon oxide layer in the same manner as in the above crack resistance evaluation. The composition a-13 was applied to the lower electrode using a spin coater at 300 rpm for five seconds and at 1000 rpm for 20 seconds, and then dried at 250°C for one minute. The resulting film 14 had a thickness of 150 nm. Occurrence of cracks was observed in the film 14 with the naked eye. The composition a-13 was diluted with ethylene glycol monomethyl ether so that a film with a thickness of 70 nm was obtained by one application/drying operation. The composition a-13 was subjected to an operation including spin coating and drying at 250°C for one minute three times and then fired at 700 °C for one hour to obtain a film 14. The film 14 was observed with the naked eye and using a microscope. As a result, it was confirmed that cracks occurred in the film 14.

Films 15 and 16 were respectively formed using the compositions a-14 and a-15 according to Comparative Examples 2 and 3 in the same manner as in the case of forming the film 14 using the composition a-13. The crack resistance of the films 15 and 16 was evaluated in the same manner as the film 14. While occurrence of cracks was not observed in the film 15, it was confirmed that cracks occurred in the film 16.

### 3.2.5-3. Evaluation of dielectric characteristics

A Pt upper electrode with a diameter of 0.2 mm and a thickness of 200 nm was formed by sputtering through a metal mask on each of the dielectric films 8 to 13 and the film 15 formed when evaluating the crack resistance. Table 4 shows the relative dielectric constant, dielectric loss, and leakage current at 0.2 mV/cm of each dielectric film measured at 1 MHz. The dielectric characteristics of the films 14 and 16 could not be evaluated due to occurrence of cracks.

**TABLE4**

| | | Composition | Relative dielectric constant | Dielectric loss (%) | Leakage current (A/cm²) |
|---|---|---|---|---|---|
| Experimental Example 7 | Dielectric film 8 | a-7 | 153 | 0.03 | 7.20E-07 |
| Experimental Example 8 | Dielectric film9 | a-8 | 227 | 0.04 | 7.40E-07 |
| Experimental Example 9 | Dielectric film 10 | a-9 | 235 | 0.03 | 1.30E-08 |
| Experimental Example 10 | Dielectric film 11 | a-10 | 186 | 0.04 | 3.20E-07 |
| Experimental Example 11 | Dielectric film 12 | a-11 | 214 | 0.03 | 4.30E-07 |
| Experimental Example 12 | Dielectric film 13 | a-12 | 245 | 0.02 | 5.40E-07 |
| Comparative Example 1 | Film 14 | a-13 | Could not be measured | Could not be measured | >1.00E-02 |
| Comparative Example 2 | Film 15 | a-14 | 23 | 0.05 | 6.3E-07 |
| Comparative Example 3 | Film 16 | a-15 | Could not be measured | Could not be measured | >1.00E-02 |

As is clear from Table 4, it was confirmed that the dielectric films formed using the dielectric-film-forming compositions according to the examples exhibited a high dielectric constant, low dielectric loss, and small leakage current and can be suitably used for a capacitor.

On the other hand, since the composition a-13 used to form the film in Comparative Example 1 was not formed using a metal hydroxide as the raw material, cracks occurred in the resulting film. In Comparative Example 2, a film exhibiting a low dielectric constant was obtained since the composition a-14 used to form the film had a molar ratio of the metal A forming the metal hydroxide (barium hydroxide monohydrate) to the metal B forming the metal alkoxide (titanium isopropoxide) of less than 0.9. In Comparative Example 3, a film exhibiting a large leakage current was obtained since the composition a-15 used to form the film had a molar ratio of the metal A forming the metal hydroxide (barium hydroxide monohydrate) to the metal B forming the metal alkoxide (titanium isopropoxide) of more than 1.1.

### BRIEF DESCRIPTION OF THE DRAWING

FIG 1 is an X-ray diffraction chart of crystal particles of Example 1.

## Claims

1. A method of producing a dielectric-film-forming composition, comprising:
(a) dissolving a metal hydroxide including a metal A which is at least one metal selected from Li, Na, Ca, Sr, and Ba and at least one of a metal alkoxide and a metal complex including a metal B which is at least one metal selected from Ti, Zr, Hf, Ta, and Nb in an organic solvent to prepare a solution; and
(b) allowing a precursor in the solution prepared in the step (a) to react.

2. The method of producing a dielectric-film-forming composition as defined in claim 1, wherein the reaction in the step (b) is effected by heating the solution prepared in the step (a).

3. The method of producing a dielectric-film-forming composition as defined in claim 1, wherein the reaction in the step (b) is hydrolysis-condensation.

4. The method of producing a dielectric-film-forming composition as defined in claim 3, wherein perovskite-type crystal particles with an average particle diameter of 100 nm or less are formed by the hydrolysis-condensation.

5. The method of producing a dielectric-film-forming composition as defined in claim 4, further comprising:
(c) purifying the perovskite-type crystal particles by using an organic solvent after the step (b).

6. The method of producing a dielectric-film-forming composition as defined in any one of claims 1 to 5,
wherein the metal A is at least one metal selected from Ca, Sr, and Ba; and
wherein the metal B is at least one metal selected from Ti, Zr, and Hf.

7. A dielectric-film-forming composition, produced by the method as defined in any one of claims 1 to 6.

8. The dielectric-film-forming composition as defined in claim 7, perovskite-type crystal particles with an average particle diameter of 100 nm or less being dispersed in the dielectric-film-forming composition.

9. A dielectric-film-forming composition, comprising:
(A) a reaction product of A1 and A2, A1 being a metal hydroxide including a metal A which is at least one metal selected from Ba, Sr, and Ca, and A2 being a metal alkoxide including a metal B which is at least one metal selected from Ti, Zr, and Hf and/or a partial hydrolysis-condensation product of the metal alkoxide; and
(B) an organic solvent,
wherein the dielectric-film-forming composition having a molar ratio of the metal A to the metal B of 0.9 to 1.1.

10. A method of forming a dielectric film, comprising:
forming a coating film by using the dielectric-film-forming composition as defined in claim 8 or 9; and
heating the coating film.

11. A dielectric film formed by heating a coating film formed by using the dielectric-film-forming composition as defined in claim 8 or 9.
